Europäisches Patentamt

European Patent Office

Office européen des brevets

(11) Numéro de publication: **0 109 994**
**A1**

## (12) DEMANDE DE BREVET EUROPEEN

(21) Numéro de dépôt: 82402233.9

(22) Date de dépôt: 07.12.82

(51) Int. Cl.³: **H 01 L 31/02**

(30) Priorité: 15.10.82 CH 6008/82

(71) Demandeur: **Orsini, Jean, Hurtado 30/32, Barcelona 32 (ES)**

(43) Date de publication de la demande: **13.06.84 Bulletin 84/24**

(72) Inventeur: **Orsini, Jean, Hurtado 30/32, Barcelona 32 (ES)**

(84) Etats contractants désignés: **AT BE DE FR GB IT LU NL SE**

(74) Mandataire: **Rinuy, Santarelli, 14, avenue de la Grande Armée, F-75017 Paris (FR)**

(54) **Procédé de création d'une configuration de contact sur un dispositif semi-conducteur et application à des cellules solaires photovoltaiques à îlot sélénium.**

(57) L'invention concerne généralement le procédé de réalisation par sérigraphie d'un contact (42) à la surface d'un semi-conducteur (40); ce contact bénéficie d'une bonne résistance mécanique de la soudure au vieillissement; en particulier, l'invention s'applique à la prise de contact sur la face postérieure des cellules solaires.

L'invention concerne aussi la fabrication d'une cellule solaire photovoltaïque à ilot de sélénium.

La cellule solaire proposée (40) est ronde; la grille principale étoilée est formée de six collecteurs principaux (47) d'électrons reliés entre eux par des capillaires concentriques.

Ce dispositif permet de concentrer – sans déperdition – les électrons formés vers l'îlot de sélénium situé au centre de la cellule.

"Procédé de création d'une configuration de contact sur un dispositif semi-conducteur et application à des cellules solaires photovoltaïques à ilôt de selenium"

La présente invention concerne un procédé de création, sur une aire de la surface d'un dispositif semi-conducteur, d'une configuration de contact apte au soudage d'une connexion métallique, ledit dispositif comportant une région d'un type de conductivité déterminé, affleurant ladite surface suivant ladite aire, procédé consistant principalement à appliquer par sérigraphie, au moins sur une partie de ladite aire, une pâte conductrice contenant notamment, dans une phase vitrifiable, un métal principal finement divisé et soudable et un élément de dopage donnant le même type de conductivité, puis ultérieurement à vitrifier thermiquement ladite pâte, dans des conditions telles que ledit dopant migre au moins dans une partie superficielle de ladite région.

La présente invention concerne également la prise de contact sur la face postérieure des cellules solaires à semi-conducteur et les cellules obtenues selon ce procédé.

On sait qu'actuellement des études intensives sont menées dans de nombreux laboratoires, pour trouver les moyens d'abaisser le prix de revient des générateurs solaires photovoltaïque. Outre le prix encore élevé du matériau semi-conducteur lui-même, certaines étapes de la fabrication des cellules solaires font obstacle à l'abaissement du prix de revient, si on conserve les procédés actuellement en usage. Il en est ainsi, particulièrement, pour ce qui est de l'opération de prise de contact sur chaque face des cellules faisant appel au dépôt par évaporation sous vide, selon les techniques éprouvées et mises au point depuis l'avènement des applications spatiales de l'énergie solaire.

Le remplacement de ladite technique d'évaporation, jugée trop onéreuse, par une technique plus aisée à automatiser et avec des matériels moins coûteux, est considéré par les spécialistes comme une mesure de valeur industrielle et économique certaine. Il est connu que l'utilisation de pâtes conductrices appliquées par sérigraphie sur les cellules solaires pourrait constituer une solution au problème évoqué, notamment au point de vue de l'économie recherchée. Par exemple, l'article de M.B. Field et L.R. Scudder paru à la suite de la 12ème Conférence des Spécialistes de l'énergie photovoltaïque tenue à Bâton Rouge - EUA - IEEE Proceedings 1976, p. 303, fait état de travaux effectués dans ce sens. Cependant le procédé qui consiste à créer un contact sur une aire de la surface d'un dispositif semi-conducteur, par exemple sur la face postérieure d'une cellule solaire (c'est-à-dire la face opposée à la phase photosensible) en utilisant la technique de sérigraphie, comporte de nombreuses difficultés parmi lesquelles il faut citer: la difficulté ultérieure de soudage à une languette de connexion lorsqu'un pourcentage élevé de l'élément de dopage est introduit dans la pâte conductrice ou bien encore l'absence d'ohmicité du contact avec résistance élevée de ce contact lorsqu'au contraire c'est un pourcentage relativement faible dudit élément de dopage qui est incorporé à ladite pâte.

Une autre difficulté est constituée par le fait, observé par le Demandeur, que la présence de l'élément de dopage dans le dépôt vitrifié du contact interfère avec ses propriétés physico-chimiques d'une manière défavorable. En effet, la tenue mécanique d'une connexion soudée audit dépôt vitrifié se dégrade de manière inacceptable lorsque le dispositif est soumis à des contraintes d'environnement sévère. Or, la longévité des générateurs d'énergie solaire représente un facteur qui leur est indispensable et revêt de ce fait une grande importance.

0109994

3

L'invention a pour but, entre autres, de remédier à ces inconvénients de manière à rendre utilisable la technique de la sérigraphie pour la prise de contact à la surface d'un dispositif semi-conducteur et particulièrement sur une cellule solaire.

La présente invention prend en considération le fait que la configuration de contact créée sur la surface d'un dispositif semi-conducteur a plusieurs fonctions qui peuvent être dissociées entre elles.

L'invention consiste en un procédé de création, sur une aire de la surface d'un dispositif semi-conducteur, d'une configuration de contact apte au soudage d'une connexion métallique, ledit dispositif comportant une région d'un type de conductivité déterminé, affleurant cette surface suivant ladite aire. Le procédé consiste principalement à appliquer par sérigraphie, sur au moins une partie de ladite aire, une pâte conductrice contenant notamment, dans une phase vitrifiable, un métalloïde principal, finement divisé et soudable, et un élément de dopage donnant le même type de conductivité, puis ultérieurement à vitrifier thermiquement cette pâte dans des conditions telles que le dopant migre au moins dans une partie superficielle de ladite région. Ce procédé est notamment remarquable en ce que, après avoir, dans un premier dépôt, appliqué sur une partie de ladite aire une pâte conductrice contenant l'élément de dopage et après avoir au moins partiellement séché ce premier dépôt, on effectue sur une plage restreinte de ladite aire qui contient l'emplacement destiné au soudage de ladite connexion, un second dépôt avec une pâte conductrice vitrifiable essentiellement dépourvue de cet élément de dopage, au moins une partie du second dépôt reposant sur une partie du premier dépôt, l'ensemble des deux dépôts constituant la configuration de contact; on effectue ensuite le traitement de vitrification.

Le procédé selon l'invention a l'avantage de permettre l'obtention d'une configuration de contact qui présente à la fois d'excellentes caractéristiques électriques, une très bonne tenue mécanique sous l'effet d'une contrainte climatique sévère et enfin une parfaite soudabilité dans les conditions opératoires habituelles.

Avantageusement, dans le procédé selon l'invention, la plage sur laquelle est localisé ledit second dépôt représente une superficie inférieure à 20 % de ladite aire et, de préférence, inférieure à 5 % seulement de ladite aire. Ainsi le dispositif manifeste alors des caractéristiques électriques qui sont très comparables à celles des dispositifs obtenus selon la technologie classique, plus onéreuse.

Dans un premier mode de mise en oeuvre de l'invention le premier dépôt est appliqué sur l'essentiel de ladite aire et le second dépôt est établi par dessus le premier dépôt.

Dans un deuxième mode de mise en oeuvre de l'invention le premier dépôt étant appliqué sur ladite aire, on y ménage au moins une réserve sur ledit emplacement de soudage. Ladite plage du second dépôt qui s'étend sur une partie du premier dépôt est alors conformée de manière à s'étendre aussi sur une zone contiguë à la réserve.

Le premier mode de mise en oeuvre est avantageux par sa simplicité. Il permet d'abaisser localement la concentration moyenne de l'élément de dopage à l'emplacement destiné au soudage de la connexion par rapport au reste de la configuration ce qui améliore à la fois la soudabilité de ladite plage et la résistance mécanique de la soudure au vieillissement; partout ailleurs le premier dépôt assure un bon contact électrique avec le matériau semi-conducteur.

Le deuxième mode de mise en oeuvre de l'invention a l'avantage, au prix d'un alignement des deux dépôts l'un sur l'autre, d'annuler la concentration en élément de dopage dans la partie de la configuration de contact qui sera utilisée au soudage de la connexion. La qualité de la soudure est alors optimale, indépendamment de la concentration en élément de dopage dans le premier dépôt.

Avantageusement ledit second dépôt est réalisé avec une épaisseur sensiblement supérieure à celle dudit premier dépôt ce qui renforce entre la longévité de la soudure de la connexion sous contrainte sévère d'environnement.

Avantageusement le traitement de vitrification des premier et second dépôts est effectué simultanément à une température comprise entre 600° et 750° C.

L'invention concerne également le dispositif, notamment pour la conversion photovoltaïque du rayonnement solaire, issu du procédé décrit, remarquable en ce que la région dudit dispositif sur laquelle est faite la prise de contact, est en Sélénium de type p, le métalloïde principal étant le bore (qui agit comme un métal) et l'élément de dopage étant de l'aluminium.

La description qui va suivre en regard des dessins annexés fera bien comprendre comment l'invention peut être réalisée au moyen d'exemples non limitatifs.

La figure 1 montre en coupe schématique une configuration de contact créée à la surface d'un dispositif par le procédé selon l'invention, suivant une première forme de mise en oeuvre.

La figure 2 montre en coupe schématique une configuration de contact électrique créée par le procédé selon l'invention dans une deuxième forme de mise en oeuvre.

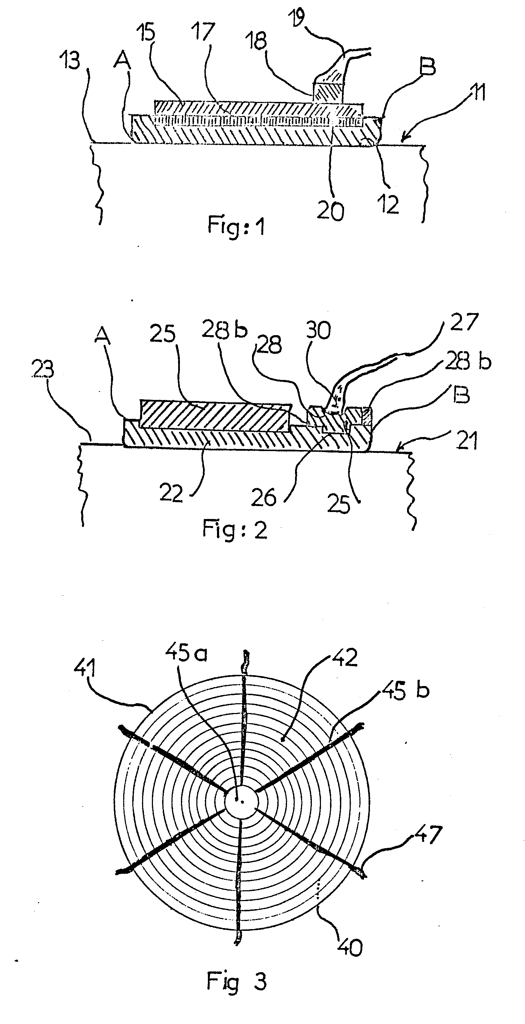

.-La figure 3 représente en plan l'application du procédé selon l'invention à la prise du contact sur la face postérieure d'une cellule solaire, sous la forme d'une grille principale de collecte étoilée.

Il est à noter que dans les figures, les proportions, notamment d'épaisseur, ne sont pas respectées de manière à rendre les dessins plus clairs.

La figure 1 montre une partie d'un dispositif semi-conducteur 11, comportant une région 12 de type p par exemple. La région 12 affleure à la surface 13 du dispositif selon une aire qui est représentée en coupe par ses limites A et B. Lorsqu'on désire établir un contact électrique avec la région 12, il importe, particulièrement lorsque ladite région 12 est à faible concentration d'impureté, de répartir ce contact sur la majeure partie de l'aire AB et de prévoir, en même temps, une élévation de la concentration d'impureté en surface de ladite région 12 de manière à rendre ohmique le contact. On applique donc, par sérigraphie à travers un écran approprié d'un type connu, un premier dépôt 15 d'une pâte conductrice qui contient, en plus des éléments habituels (solvant, liant organique, verre fusible, métal principal finement divisé choisi pour ses qualités électriques et de soudabilité) un élément de dopage qui est chargé, au cours d'un traitement thermique ultérieur, de migrer dans une pellicule superficielle 17 de la région 12 pour en enrichir la concentration d'impureté. Selon l'invention, après application de ce premier dépôt 15, on effectue une application localisée d'un second dépôt 18 d'une pâte conductrice sérigraphiée, pâte qui, pour ce second dépôt, est essentiellement exempte d'élément de dopage. La plage formée par le second dépôt 18 est une fraction restreinte de l'aire AB sur laquelle le contact doit être établi. Elle est destinée à la soudure de la languette de connexion 19.

Dans le mode de mise en oeuvre du procédé illustré par l'exemple de la figure 1, le premier dépôt 15 de pâte conductrice est appliqué uniformément sur la majeure partie de l'aire AB alors que le second dépôt 18 est sérigraphié par dessus le premier dépôt 15. Ce procédé permet de choisir une concentration d'élément de dopage dans le premier dépôt 15 qui soit suffisante pour que le contact entre ce dépôt et le semi-conducteur de la région 12 ait de bonnes caractéristiques d'ohmicité et qui soit cependant assez modérée pour que la migration dudit élément de dopage dans le second dépôt 18 au cours du traitement thermique de vitrification, ne nuise pas à la soudabilité de la languette de connexion 19. La migration de l'élément de dopage de la portion 20 du premier dépôt 15 vers le dépôt 18 offre l'avantage que la concentration globale en élément de dopage reste faible dans l'ensemble du dépôt 18 et de la portion 20. On a donc dissocié au sein de la configuration de contact constituée par l'ensemble des deux dépôts 15 et 18 la fonction de contact proprement dite avec le corps semi-conducteur, et la fonction de liaison par soudage à une connexion métallique. Ceci est très favorable pour assurer à la soudure une tenue mécanique qui soit très résistante même sous contrainte sévère d'environnement et, aussi, pour obtenir une soudabilité de la connexion qui soit parfaite.

Dans les limites de la portion 20 du premier dépôt 15, le contact électrique avec le semi-conducteur peut être déficient puisque la concentration en élément de dopage y est faible selon ce qui vient d'être expliqué. Ceci, conformément à l'invention, n'entraîne pratiquement pas de conséquence mesurable du fait que la plage localisée du second dépôt 18 est de superficie restreinte vis-à-vis de l'aire AB. Avantageusement cette superficie est inférieure à 20 % de ladite aire et de préférence inférieure à 5 % seulement. De plus, la forme géométrique elle-même du second dépôt 18 peut contribuer, dans la mesure où elle est étroite et allongée, à minimiser encore la résistance de conduction dans la portion 20 du matériau semi-conducteur de la région 12 qui est située à l'aplomb du second dépôt 18.

A titre d'exemple de réalisation le dispositif semi-conducteur 11 est en SELENIUM, la région 12 est de type p avec une concentration d'impureté, sensiblement homogène de l'ordre de $10^{16}$ cm$^{-3}$. Le premier dépôt 15 est appliqué par sérigraphie d'une pâte d'un type connu et disponible sur le marché, qui contient essentiellement: de la poudre de BORE en tant que métal principal, un matériau passif du type verre de scellement (généralement un borosilicate de zinc), un liant organique temporaire comme l'éthyl-cellulose à propriétés thixotropiques convenables et un solvant comme le terpinéol, pâte à laquelle on a préalablement incorporé 0,8 à 2 % en poids de poudre d'aluminium en tant qu'élément de dopage. L'écran de sérigraphie utilisé est en fil d'acier inoxydable de 60 microns de diamètre tissé en formant une maille de 100 microns de côté.

Le premier dépôt 15 est séché quelques minutes à 150° C environ pour éliminer le solvant contenu dans le dépôt. Après quoi, on applique, par sérigraphie localisée, le second dépôt 18 avec une pâte au BORE semblable à la première, à la différence qu'on n'y incorpore pas de poudre d'aluminium. Le second dépôt est séché à son tour, par un traitement du dispositif à 150° C, puis le dispositif est porté à 400° C pour éliminer le liant organique de l'ensemble des dépôts. Enfin, une cuisson de vitrification intervient à une température de préférence comprise entre 600° C et 750° C, pendant 15 minutes environ, cuisson au cours de laquelle une partie de l'aluminium contenu dans le premier dépôt 15 interagit sur la surface de SELENIUM et forme, après refroidissement, la pellicule 17 de SELENIUM, riche en aluminium. La languette de connexion 19, en cuivre étamé par exemple, est très aisément soudée sur la plage du second dépôt 18 à l'aide d'un alliage conventionnel de Pb-Sn.

On se reporte maintenant à la figure 2 relative à une variante du procédé selon l'invention.

La région 22, du type p par exemple, affleure la surface 23 du dispositif 21 suivant l'aire AB représentée sur la figure en coupe. Dans ce mode particulier et avantageux de l'invention, le premier dépôt 25 de pâte conductrice vitrifiable contenant l'addition d'un élément de dopage est appliqué sur la majeure partie de l'aire AB à l'exception d'une réserve 26 dont l'emplacement correspond sensiblement à celui où sera pratiqué ultérieurement le soudage de la connexion 27. Ladite réserve est obtenue en incorporant de manière connue un masque convenable à l'écran de sérigraphie. Le procédé se déroule ensuite de manière similaire à ce qui a été décrit à propos de l'exemple de la figure 1, à la différence près que le second dépôt 28, de pâte conductrice, exempte d'élément de dopage, se trouve localisé de manière conjuguée avec la réserve 26 pratiquée dans le premier dépôt 25. En effet, la plage du second dépôt 28 s'étend à la
fois sur l'emplacement de la réserve 26 où ledit second dépôt repose à la surface du semi-conducteur de la région 22,
et à la fois sur une zone 28b qui est contiguë audit emplacement où ledit second dépôt 28 repose alors sur le premier
dépôt 25. Selon cette variante du procédé, à l'emplacement
de la réserve 26, le dépôt sérigraphié ne contient pas d'élément de dopage ce qui a l'avantage de permettre le soudage
de la connexion 27 sur cet emplacement dans d'excellentes
conditions et d'assurer une robustesse optimale de la liaison soudée du fait qu'aucune perturbation physico-chimique
causée par l'élément de dopage ne peut intervenir. La zone
28b sur laquelle les deux dépôts sérigraphiés se recouvrent
assure la continuité électrique du contact entre la région 22
et la connexion 27. A l'emplacement de la réserve 26, le
contact entre le second dépôt 28 et le matériau de la région
22 est électriquement inactif.

L'inactivité d'une portion de la configuration de
contact n'entraîne pas de conséquence nuisible, comme il a
été déjà expliqué, du fait que, selon l'invention, la plage
du second dépôt 28 est de superficie très restreinte par
rapport à l'aire AB sur laquelle la configuration de contact
doit être créée. Un autre avantage de ce mode de mise en oeuvre de l'invention est que la concentration en élément de dopage dans le premier dépôt 25 peut être augmentée à volonté
sans risquer de retomber dans les difficultés de l'art antérieur. Par exemple, dans le cas de la pâte de BORE on peut
utiliser jusqu'à 15 % d'aluminium sans inconvénient.

Avantageusement le second dépôt 28 est réalisé avec
une épaisseur sensiblement supérieure à celle du premier
dépôt 25, ce qui éloigne d'autant plus de la surface de la
région 22 la soudure 30 de la connexion 27 et renforce la
robustesse de la liaison mécanique sous l'effet des contraintes d'environnement sévères. Par exemple, si le premier dépôt
25 est réalisé avec une épaisseur de 10 microns on s'efforce
d'atteindre environ 20 microns pour l'épaisseur du second
dépôt 28.

On se reporte maintenant à la figure 3 pour décrire un exemple d'application du procédé selon l'invention à la prise de contact sur la face postérieure d'une cellule solaire au SELENIUM. La cellule 40, de forme circulaire, a sa face photosensible du côté non visible sur la figure, tandis que la face 41, qui lui est opposée, comporte la configuration de contact 42 sur l'essentiel de sa surface. En effet cette configuration est appliquée sur le matériau semi-conducteur d'origine, c'est-à-dire faiblement concentré en impureté de dopage; aussi est-il habituel dans l'art, de répartir au maximum sur la face postérieure 41 le métal ou métalloïde de contact de manière à réduire autant que possible la résistance interne de la cellule. Dans l'exemple décrit, le dépôt 42 est appliqué par sérigraphie d'une pâte conductrice contenant un élément de dopage de manière à permettre un contact ohmique de faible résistance sur le matériau semi-conducteur d'origine. Selon l'invention un second dépôt de pâte conductrice est appliqué au moyen d'une opération supplémentaire de sérigraphie, opération qui est localisée aux deux plages 45a et 45b. Ce second dépôt, selon l'une des caractéristiques de l'invention est effectué avec une pâte conductrice qui ne contient pas d'élément de dopage. La languette de connexion 47, en cuivre étamé, est ultérieurement soudée au centre des plages 45a et 45b à l'aide d'un alliage standard en plomb-étain.

Les opérations qui, par ailleurs, permettent d'obtenir la cellule avec ses caractéristiques propres habituelles, sont bien connues dans l'art.

La configuration de contact de la face antérieure photosensible peut être obtenue par exemple en ayant recours à la technique classique faisant appel à l'évaporation sous vide de BORE et de BROME à travers un masque métallique pour assurer la forme découpée habituelle du contact. Dans ce cas il est avantageux de réaliser d'abord les dépôts de pâtes conductrices sur la face postérieure de la cellule, d'opérer les traitements thermiques de ces pâtes y compris la cuisson

0109994

11

de vitrification à une température de l'ordre de 600° à 750°C, puis ensuite, d'effectuer l'évaporation de BORE + BROME sur la face antérieure de la cellule suivie d'un recuit à environ 450°. Ceci permet, en procédant dans cet ordre, d'éviter de faire subir à la métallisation de la face antérieure un traitement à une température inutilement élevée, traitement qui risquerait de détériorer les caractéristiques électriques de la région photosensible. On peut alors procéder au soudage des connexions électriques sur les deux faces de la cellule.

Le procédé selon l'invention, quoique particulièrement bien adapté à l'établissement d'un contact sur la face antérieure comme sur la face postérieure de cellules solaires peut encore être appliqué à d'autres dispositifs semi-conducteurs notamment lorsqu'une région électrique de dimensions assez importantes, doit être connectée vers un circuit extérieur alors que ladite région est faiblement concentrée en impureté à sa surface.

Bien entendu, l'invention n'est pas limitée aux exemples de réalisation ci-dessus décrits et représentés, à partir desquels on pourra prévoir d'autres modes et d'autres formes de réalisation sans pour cela sortir du cadre de l'invention.

Par ailleurs, on notera que l'expression "métalloïde" utilisée dans cette demande est équivalente à celle de "métal" habituellement employée pour les dispositifs semi-conducteurs, du fait des similitudes quant aux caractéristiques de conductivité.

0109994

1

<u>REVENDICATIONS</u>

1. Procédé de création, sur une aire de la surface d'un dispositif semi-conducteur, d'une configuration de contact apte au soudage d'une connexion métallique, ce dispositif comportant une région d'un type de conductivité déterminé affleurant la surface suivant ladite aire; le procédé étant caractérisé en ce qu'il consiste : à appliquer par sérigraphie, sur au moins une partie de ladite aire, une pâte conductrice contenant notamment, dans une phase vitrifiable, au moins un métalloïde principal, finement divisé et soudable, et un élément de dopage donnant le même type de conductivité; puis ultérieurement, à vitrifier thermiquement ladite pâte, dans des conditions telles, que ledit dopant migre dans au moins une partie superficielle de ladite région.

2. Procédé selon la revendication 1, caractérisé en ce que, après avoir par un premier dépôt, appliqué sur au moins une partie de ladite aire la pâte conductrice contenant l'élément de dopage et après avoir, au moins partiellement, séché ledit premier dépôt, on effectue sur une partie du premier dépôt et selon une plage restreinte de ladite aire qui contient l'emplacement destiné au soudage de ladite connexion, un second dépôt avec une pâte conductrice vitrifiable essentiellement dépourvue dudit élément de dopage, une partie au moins du second dépôt reposant sur une partie du premier dépôt, l'ensemble des deux dépôts constituant ladite configuration de contact; puis en ce que l'on effectue ensuite le traitement de vitrification.

3. Procédé selon l'une quelconque des revendications 1 ou 2 caractérisé en ce que ladite plage restreinte sur laquelle est effectué le second dépôt représente une superficie inférieure à 20 % de ladite aire.

4. Procédé selon la revendication 3 caractérisé en ce que ladite plage représente une superficie qui est inférieure à 5 % de ladite aire.

2

5. Procédé selon l'une quelconque des revendications 1 ou 2, caractérisé en ce que le premier dépôt est appliqué sur l'essentiel de ladite aire, le second dépôt étant effectué par dessus le premier dépôt.

6. Procédé selon l'une quelconque des revendications 1 à 4, caractérisé en ce que, le premier dépôt étant appliqué sur ladite aire, on y ménage une réserve sur ledit emplacement de soudage, le second dépôt, qui s'étend sur une partie du premier dépôt, étant effectué non seulement sur cette réserve mais aussi sur une zone contiguë à cette dernière.

7. Procédé selon l'une quelconque des revendications 2 à 6, caractérisé en ce qu'on réalise le second dépôt avec une épaisseur sensiblement supérieure à celle du premier dépôt.

8. Procédé selon l'une quelconque des revendications 1 à 7, caractérisé en ce que ladite région du dispositif est en sélénium, le métalloïde principal étant du bore et l'élément de dopage l'Aluminium, et en ce que la proportion pondérale d'aluminium dispersé dans la pâte conductrice dopée est comprise entre 0,8 % et 15 %.

9. Procédé selon la revendication 8, caractérisé en ce que la proportion d'aluminium est comprise entre 0,8% et 2 %.

10. Procédé selon l'une quelconque des revendications 1 à 9, caractérisé en ce que le traitement de vitrification des premier et second dépôts est effectué simultanément à une température comprise entre 600 et 750°C.

11. Dispositif semi-conducteur obtenu par le procédé selon l'une quelconque des revendications 1 à 10 et utilisable notamment pour la conversion photovoltaïque du rayonnement solaire, caractérisé en ce que ladite région du dispositif est en sélénium, le métalloïde est choisi dans le groupe bore et brome et l'élément de dopage est de l'aluminium anodisé.

- 1 -

0109994

Fig: 1

Fig: 2

Fig 3

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. ³) |
|---|---|---|---|
| X,Y | EP-A-0 002 550  (PHILIPS)<br>* Page 3, ligne 17 - page 12, ligne 17; revendications * | 1-11 | H 01 L  31/02 |
| | --- | | |
| Y | DE-A-2 525 272  (WOLFGANG KÜNZEL)<br>* Page 2, dernier alinéa - page 3, dernier alinéa; revendications * | 1,8 | |
| | --- | | |
| A | FR-A-2 443 746  (EXXON RESEARCH AND ENGINEERING)<br>* Revendications; figure 1 * | 1,8 | |
| | --- | | |
| A | PATENTS ABSTRACTS OF JAPAN, vol. 6, no. 243 (E-145)[1121] 2 décembre 1982<br>& JP - A - 57 141 979 (SHIYUNPEI YAMAZAKI) 02-09-1982 * Résumé * | 1,8 | DOMAINES TECHNIQUES RECHERCHES (Int. Cl. ³)<br><br>H 01 L |
| | --- | | |
| A | US-A-4 293 451  (BERND ROSS)<br>* Revendications * | 1,8-11 | |
| | ----- | | |

Le présent rapport de recherche a été établi pour toutes les revendications

| Lieu de la recherche | Date d'achèvement de la recherche | Examinateur |
|---|---|---|
| LA HAYE | 20-01-1984 | GORUN M. |